# EUROPEAN PATENT SPECIFICATION

(11) **EP 0 504 824 B1**
(45) Date of publication and mention of the grant of the patent: **14.01.1998**
(21) Application number: 92104626.4
(22) Date of filing: 18.03.1992
(51) Int. Cl.: G03F 7/11, G03F 7/09

(54) **Photosensitive printing element**
Lichtempfindliches Druckelement
Elément d'impression photosensible

(30) Priority: 20.03.1991 US 672872
(43) Date of publication of application: 23.09.1992
(73) Proprietor: E.I. DU PONT DE NEMOURS AND COMPANY, Wilmington Delaware 19898 (US)
(72) Inventor: Swatton, David William, Red Bank, New Jersey 07701 (US); Kudva, Ashok K., Hendersonville, North Carolina 28739 (US)
(74) Representative: Werner, Hans-Karsten, Dr.Dipl.-Chem.

(56) References cited:
- EP-A- 0 084 851
- EP-A- 0 165 030
- EP-A- 0 318 780
- GB-A- 2 003 621

## Description

### FIELD OF THE INVENTION

This invention relates to a photosensitive printing element which can be used to prepare a flexographic printing plate. More particularly, it relates to a photosensitive printing element which can be used to prepare a flexographic printing plate having improved printing characteristics.

### BACKGROUND OF THE INVENTION

Photosensitive elements which can be used to prepare flexographic printing plates generally comprise a support and a photosensitive or "photopolymerizable" layer comprising (1) an addition polymerizable nongaseous ethylenically unsaturated monomer, (2) a photoinitiating system activatable by actinic radiation, and (3) an elastomeric or thermoplastic-elastomeric polymeric binder. Frequently, a clear adhesive layer is situated between the support and the photosensitive layer to improve the adhesion between these two layers. In addition, the adhesive layer generally contains an antihalation agent to improve resolution.

Processes for producing a flexographic printing plate from a photosensitive element are well known in the art. Typically, the element is first given a brief, overall exposure to actinic radiation through the support to produce a thin layer of polymerized material, or "floor," next to the support. The element is then exposed imagewise to actinic radiation through the other side to produce exposed areas and unexposed areas. The unexposed areas are subsequently washed off using a suitable developer solvent. The plate is then dried and optionally treated to remove surface tackiness and/or post-exposed to actinic radiation to ensure complete polymerization and maximize plate hardness.

It has been found that the floor of polymerized material is frequently not uniform, with the appearance of high spots, or "bumps," on the surface of the floor. This can result in defects in the printing process. In non-image areas the bumps can actually pick up ink and print. In areas of fine highlight dots, the bumps can cause unwanted polymerization during processing which results in the filling in of the dots. In either case, printing quality is diminished.

The non-uniformities or bumps in the plate floor are believed to be caused by non-uniformities in the antihalation-containing adhesive layer between the support and the photosensitive layer. The non-uniformities allow excess light to penetrate the photosensitive layer in some areas during the initial overall exposure to actinic radiation through the support. This results in increased polymerization in these areas and the formation of the bumps. It is not always possible to eliminate the coating defects. Improving coating uniformity generally involves slower coating speeds. This increases production costs and is therefore, not a very attractive option. In addition, there is a limit to the uniformity attainable even at slower coating speeds.

Accordingly, an object of this invention is to provide a photosensitive element which can be used to prepare an improved flexographic printing plate in which defects caused by adhesive layer non-uniformities have been substantially reduced.

### SUMMARY OF THE INVENTION

This invention relates to a photosensitive printing element comprising:
(a) a transparent film support comprising a synthetic resin and at least 0.1 weight %, based on the weight of the film, of an antihalation agent;
(b) a transparent adhesive layer; and
(c) a photopolymerizable layer comprising (i) at least one nongaseous ethylenically unsaturated monomer, (ii) a photoinitiator system and (iii) an elastomeric binder comprising polymerized conjugated diene monomers.

In a preferred embodiment of this invention, the photosensitive printing element described above further comprises a multilayer cover element adjacent to the photopolymerizable layer. The multilayer cover element consists essentially of a flexible cover film, a layer of an elastomeric composition, and optionally, a flexible polymeric film. The layer of elastomeric composition is in contact with the photopolymerizable layer and is photosensitive or becomes photosensitive by contact with the photopolymerizable layer. The elastomeric layer comprises an elastomeric polymeric binder, a second polymeric binder and optionally a nonmigratory dye or pigment. If a flexible polymeric film is used, it is present adjacent to the cover film.

In another embodiment, this invention relates to a process for improving the printing quality of a flexographic printing plate, as defined in claim 5.

### DETAILED DESCRIPTION OF THE INVENTION

The photosensitive printing elements of this invention can be used to prepare flexographic printing plates with a more uniform printing floor. The improved uniformity is due to the incorporation of an antihalation agent into the support film and the use of an adhesive layer which contains no dyes or UV-absorbing materials.

A film must be transparent and flexible to function acceptably as a support. By "transparent" it is meant that the film transmits enough actinic radiation at the wavelength at which the photoinitiating system is activated to cause polymerization of the photopolymer layer. The film must be flexible enough to wrap around a printing cylinder and remain attached in that configuration during the printing process. Suitable materials include various film-forming synthetic resins or polymers such as the addition polymers and linear condensation polymers. Preferred support materials are polyester films, such as polyethylene terephthalate.

The transparent film support also comprises an antihalation agent. Halation is the loss of resolution caused by scattered and reflected actinic radiation, so named because in silver halide film, the light scattered and reflected produced halos around images. In the preparation of flexographic printing plates from photosensitive elements, incident radiation from the imagewise exposure is scattered and reflected at the back of the support and at the support-adhesive interface. This causes halation, i.e., the photopolymer layer is exposed to radiation and polymerized in regions in which exposure and polymerization is not desired. The antihalation agent absorbs the reflected actinic radiation and thus prevents the undesired photopolymerization.

To be effective, an antihalation agent must absorb radiation at the same wavelength range that is used to imagewise expose the photosensitive element, i.e., the wavelength range that is used to activate the photoinitiating system. Most photoinitiating systems are sensitive to radiation in the ultraviolet region. Accordingly, most effective antihalation agents are UV-absorbers. Examples of suitable UV-absorbers include hydroxy- or alkoxybenzophenones and substituted benzotriazoles. Preferred UV-absorbers which are useful with polyethylene terephthalate films are disclosed in U.S. Patent 4,278,589. Particularly preferred is 2-(3',5'-bis(1-methyl-1-phenylethyl)-2'-hydroxyphenyl)benzotriazole. The antihalation agent can be clear or colored as long as it does not prevent the transmission of actinic radiation through the support. A combination of antihalation agents can be used.

The antihalation agent should be compatible with the polymer or resin in the film, i.e., it should result in a uniform and non-cloudy film. The amount of antihalation agent present should be sufficient to prevent polymerization from reflected actinic radiation. It will be appreciated that the amount needed will vary with the extinction coefficient of the antihalation agent and with the composition and thickness of the photopolymer layer. In general, for photopolymer layers of 75 mils (0.19 cm) or less in thickness, the antihalation agent should be present in an amount of at least about 0.1 wt%, based on the total film weight.

If desired, the film support may also comprise other additives, such as dyes or colorants, as long as they do not interfere with the transmission characteristics and flexibility of the film as discussed above.

The thickness of the support film can also vary depending on the thickness of the photopolymer layer and the design of the ultimate printing system. However, in most cases the support has a thickness in the range of about 2 to 10 mils (0.005 to 0.025 cm).

The adhesive layer of the photosensitive element of the invention must be (1) flexible, (2) stable to all the processing steps, (3) provide sufficient adhesion between the support film and photopolymer layer throughout the developing and printing stages and (4) be transparent to the wavelength range of actinic radiation used. Examples of suitable adhesives include polyvinyl chlorides, polyurethanes. Particularly preferred are polyvinylidene chloride based polymers. The adhesive layer can contain additives such as coating aids, but should not contain any materials which absorb radiation in the same range as the photoinitiating system. The adhesive layer is generally as thin as possible while still providing adequate adhesion. Coating thicknesses from 5 to 100 mg/dm² are usually acceptable.

The photopolymerizable layer of the photosensitive element of the invention comprises (i) at least one nongaseous ethylenically unsaturated monomer, (ii) a photoinitiator system and (iii) an elastomeric binder comprising polymerized conjugated diene monomers. Suitable monomers are addition-polymerizable ethylenically unsaturated compounds. The photopolymerizable layer can contain a single monomer or a mixture of monomers which must be compatible with the binder to the extent that a clear, non-cloudy photosensitive layer is produced. Monomers that can be used in the photopolymerizable layer are well known in the art. Examples of such monomers can be found in U.S. Patents 4,323,636; 4,753,865; 4,726,877; and 4,894,315. It is preferred that the monomer be present in at least an amount of 5% by weight of the photopolymerizable layer.

The photoinitiating system can be practically any organic compound or group of compounds which is radiation sensitive, free radical generating and which initiates polymerization of the monomer or monomers without excessive termination. It should be activatable by actinic radiation and thermally inactive at and below 185°C. Photoinitiating systems of this type include the substituted and unsubstituted polynuclear quinones. Examples of suitable systems have been disclosed in Gruetzmacher et al., U.S. Patent 4,460,675 and Feinberg, U.S. Patent 4,894,315. Photoinitiating systems are generally present in amounts from 0.001% to 10.0% based on the weight of the photopolymerizable composition.

The binder is an elastomeric polymer. The binder can be a single polymer or mixture of polymers which can be soluble or dispersible in aqueous, semi-aqueous or organic solvent developers. Binders which are soluble or dispersible in aqueous or semi-aqueous developers have been disclosed in U.S. Patents 3,458,311; 4,442,302; 4,361,640; 3,794,494; 4,177,074; 4,431,723; and 4,517,279. Binders which are soluble or dispersible in organic solvent developers include natural or synthetic polymers of conjugated diolefin hydrocarbons, including 1,2-polybutadiene, 1,4-polybutadiene, butadiene/acrylonitrile, butadiene/styrene, thermoplastic-elastomeric block copolymers, e.g., styrene-butadiene-styrene block copolymer, styrene-isoprene-styrene block copolymer, etc., and copolymers of the binders. The block copolymers discussed in U.S. Patent Nos. 4,383,646; 4,430,417; and 4,045,231, can be used. The Kraton® family of triblock copolymers are manufactured by the Shell Chemical Company (Houston, TX) and are also suitable for practicing this invention. It is preferred that the binder be present in at least an amount of 65% by weight of the photosensitive layer.

The term binder, as used herein, encompasses core shell microgels and blends of microgels, and preformed macromolecular polymers, such as those disclosed in U.S. Patent 4,894,315.

The photopolymerizable layer can also contain a thermal polymerization inhibitor. Inhibitors which can be used include: p-methoxyphenol, hydroquinone, and alkyl and aryl-substituted hydroquinones and quinones, tert-butyl catechol, pyrogallol, copper resinate naphthalamines, beta-naphthol, cuprous chloride, 2,6-di-tert-butyl-p-cresol, phenothiazine, pyridine, nitrobenzene and dinitrobenzene, p-toluquinone and chloranil. The N-nitroso compositions disclosed in U.S. Patent No. 4,168,982 are also useful thermal polymerization inhibitors. In this invention, inhibitors are usually present in an amount at least 0.001% by weight of the photopolymerizable composition.

The photopolymerizable layer can contain other additives depending on the final properties desired. Such additives include plasticizers, colorants, antioxidants, antiozonants, fillers or reinforcing agents.

A transparent cover sheet such as a thin film of polystyrene, polyethylene, polypropylene or other strippable material can be used as a cover element to prevent contamination of or damage to the photopolymerizable layer during storage or manipulation. The cover sheet can also include a thin, hard, flexible solvent-soluble layer, e.g., a layer of a polyamide, copolymer of polyethylene and polyvinyl acetate, etc., can be used on the upper surface of the photopolymerizable layer to protect for reuse, the image-bearing negative or transparency superposed thereon, or to improve contact or alignment with the photosensitive surface.

In the present invention, it is preferred to use a multilayer cover element consisting essentially of a flexible cover film, optionally a flexible polymeric film, and a layer of an elastomeric composition which is photosensitive or becomes photosensitive by contact with the photopolymerizable layer. Such multilayer cover elements are disclosed in Gruetzmacher et al. U.S. Patent Nos. 4,427,759 and 4,460,675. The flexible cover film, which can be subcoated, is generally polyester, polystyrene, polyethylene, polypropylene or other strippable film.

The optional flexible polymeric film layer is present adjacent to the cover film. This layer is soluble or strippable in developer solutions during processing of the exposed element to form a relief image and is preferably a polyamide, copolymer of ethylene and vinyl acetate, etc.

The elastomeric layer of the multilayer cover element should have an elastic modulus in the polymerized state not substantially less than the elastic modulus of the photopolymer layer in the exposed state. The elastomeric composition comprises an elastomeric polymeric binder, a second polymeric binder and optionally a nonmigratory dye or pigment. The elastomeric polymeric binder in the elastomeric composition is generally the same as or similar to the elastomeric binder present in the photopolymer layer.

The photopolymer compositions of this invention can be prepared in many ways by admixing the binder, monomer, initiator, and other ingredients. However, it is preferred that the photopolymerizable element be made by forming the photopolymer mixture into a hot melt. This can be carried out by placing the mixture in a mixing device such as a rubber mill which can be part of a calender device. Alternatively, the mixture can be placed in an extruder which performs the function of melting, mixing, deaerating and filtering the composition. A twin screw extruder or other extruders known to those skilled in the art can be used. The temperature of the melt in the extruder is within the range of about 130° to 230°C, and the composition remains in the extruder for about 0.5 to 5 minutes.

The adhesive can be coated directly onto the support film of the invention. The photopolymerizable composition can then be applied directly to the adhesive-coated support. The photopolymerizable layer is generally calendered to effect a thin, smooth sheet. Calendering is accomplished by passing the photopolymerizable composition from the mixing device or extruder into the nip of a calender and calendering while hot between the adhesive coated support and a cover layer, preferably the multilayer cover element described above.

Alternatively, the photopolymerizable material can be placed between the support and a cover layer in a mold. The support can be coated with adhesive prior to the molding step and the photopolymerizable material placed on the adhesive side, or a layer of adhesive film can be placed between the support and the photopolymerizable material. The layers of material are then pressed flat by the application of heat and/or pressure. The cover layer can be any of the materials discussed above and is preferably the multilayer cover element. The photopolymerizable material can also be pressed between two removable support materials. An assembly of support film containing antihalation agent, adhesive, photopolymer, and cover element can then be laminated together.

In general, the process of preparing a flexographic printing plate from a photopolysensitive element includes the steps of back exposure through the support main image exposure, development or washout, and post-development treatment. Post-development treatment can include any or all of the following: drying, overall post-exposure, and surface detackification.

The back exposure generally uses a radiation source the same as or similar to that used for the main imagewise exposure, as discussed below. It serves to sensitize the plate and established the depth of the plate relief. The back exposure gives the photopolymer layer a uniform and relatively short exposure through the support, thereby photocrosslinking the binder and monomer in the support region to produce the floor.

Printing reliefs can be made from the photosensitive elements of this invention by exposing to actinic radiation selected portions of the photopolymerizable layer through an image-bearing transparency. The ethylenically unsaturated monomer is polymerized or crosslinked in those areas exposed to actinic radiation resulting in reduced solubility or swellability in developer solvents. No significant polymerization or crosslinking takes place in the unexposed areas of the layer. The image-bearing transparency can be constructed of any suitable material including cellulose acetate film and oriented polyester film.

Actinic radiation from any source and of any type can be used in the photopolymerization process. The radiation can emanate from point sources or be in the form of parallel rays or divergent beams. By using a broad radiation source relatively close to the image-bearing transparency, the radiation passing through the clear areas of the transparency enters as divergent beams and thus irradiates a continually diverging area in the photopolymerizable layer beneath the clear portions of the transparency. This results in a polymeric relief having its greatest width at the bottom of the photopolymerizable layer, i.e., a frustum, and the top surface of the relief have the dimensions of the clear area.

The free-radical generating systems activatable by actinic radiation generally exhibit their maximum sensitivity in the ultraviolet range, therefore, the radiation source should furnish an effective amount of this radiation preferably having a wavelength range between about 250 nm and 500 nm, and more preferably 300 to 420 nm. In addition to sunlight, suitable radiation sources include carbon arcs, mercury-vapor arcs, fluorescent lamps, lasers, electron flash units and photographic flood lamps. Electron accelerators and electron beam sources through an appropriate mask can also be used. The most suitable source of radiation are the mercury-vapor lamps, particularly the sun lamps, are most suitable. A standard radiation source is the Sylvania 350 Blacklight fluorescent lamp (FR 48T12/350 VL/VHO/180, 115 w) (registered trade mark) which has a central wavelength of emission around 354 nm.

The radiation exposure time can vary from fractions of a second to minutes, depending upon the intensity and spectral energy distribution of the radiation, its distance from the photosensitive element, and the nature and amount of the photopolymer composition. Typically a mercury vapor arc or a sunlamp is used at a distance at about 1.5 to about 60 inches (3.8 to 153 cm) from the photosensitive element. Exposure temperatures are preferably ambient or slightly higher, i.e., about 20° to about 35°C.

Following imagewise exposure the image can be developed by washing with a suitable developer. Development is usually carried out at about room temperature. Preferred aqueous developers usually contain a water miscible organic solvent and an alkaline material. Suitable water miscible organic solvents include isopropanol, butanol, diacetone alcohol, 1-methoxyethanol, 2-ethyoxyethanol, and 2-n-butoxyethanol. Suitable alkaline materials include alkali metal hydroxides. A preferred developer is a water/isopropanol solution (90/10 v/v) containing 0.1-0.3% by weight sodium hydroxide. Other suitable aqueous developer combinations are described in U.S. Pat. No. 3,796,602.

Suitable ceramic solvent developers for the compositions of the present invention include aromatic or aliphatic hydrocarbon and aliphatic or aromatic halohydrocarbon solvents, for example, perchloroethylene, 1,1,1-trichloroethane tetrachloroethane, trichloroethylene, benzene, toluene, xylene, hexane, isononylacetate, methylisobutylketone, or mixtures of such solvents with suitable alcohols. Other organic solvent developers have been disclosed in published German Application No. 3828551.

Development time can vary, but it is preferably in the range of about 5 to 25 minutes. Developer can be applied in any convenient manner, including immersion, spraying and brush or roller application. Brushing aids can be used to remove to the unpolymerized or non-crosslinked portions of the composition. However, washout is frequently carried out in an automatic processing unit which uses solvent and mechanical brushing action to remove the unexposed portions of the plate, leaving a relief constituting the exposed image and floor.

Following solvent development, the relief printing plates are generally blotted or wiped dry, and then dried in a forced air or infrared oven. Drying times and temperature may vary, however, typically the plate is dried for 60 to 120 minutes at 60°C. High temperatures are not recommended because the support can shrink and this can cause registration problems. Additional air drying overnight for 16 hours or more is common. The solvent will continue to evaporate from the printing relief during drying at ambient conditions.

Most flexographic printing plates are uniformly post-exposed to ensure that the photocrosslinking process is complete and that the plate will remain stable during printing and storage. This "post-exposure" step utilizes the same ultraviolet radiation source as the main exposure i.e. most preferably, wavelengths of 300 to 420 nm. Although post-exposure is carried out to complete polymerization and maximize plate durability, it does not remove surface tackiness.

Detackification is an optional post-development treatment which can be applied if the surface is still tacky. Tackiness can be removed by methods well known in the art such as treatment with bromine or chlorine solutions. See, e.g., U.S. Pat. No. 4,400,460 and German Patent, DE No. 2 823 300. In addition, U.S. Pat. No. 4,400,459 to Gruetzmacher et al., teaches a process for detackifying photosensitive elastomeric flexographic printing plates, wherein the developed dried surface is, in either order, (1) post-exposed to actinic radiation, and (2) treated with a solution of an alkali monopersulfate and a bromide salt.

Exposure to radiation sources having a wavelength not longer than 300 nm has also been used to remove plate tackiness. For example, European Published Patent Application No. 0 017927 to Nakjamura et al. describes a process for detackifying a photosensitive elastomeric printing plate using a light source emitting light with a wavelength in the range of 200 to 300 nm. The light sources disclosed include heavy-hydrogen lamps, low-pressure mercury lamps, and germicidal lamps. Gibson, U.S. Patent No. 4,806,506, teaches an improved process for detackifying an imagewise exposed and solvent-developed photopolymeric flexographic relief printing plate wherein an aprotic organic solvent is applied to the surface of the printing plate after the developed plate is dried by prior to irradiation with light having wavelengths in the 200 to 300 nm range. As discussed above, the light finishing exposure can also be accomplished using a high intensity radiation source such as the Fusion lamp or Western Quartz lamp (registered trade mark).

The advantageous properties of this invention can be observed by reference to the following examples which illustrate but do not limit the practice of the invention.

### EXAMPLES

### GLOSSARY

### Materials

- PET: = polyethylene terephthalate
- Blue 3R-RF: = a mixture of 90% Macrolex Blue RR, CI Solvent Blue 97 and 10% Macrolex Violet B, CI Solvent Violet 13 both from Mobay Chemical, Union, NJ
- UV absorber: = 2-[3',5'-bis (1-methyl-1-phenylethyl)-2'-hydroxyphenyl]benzo-triazole
- CP1216: = latex of 2.8 parts poly(vinylidenechloride/itaconic acid/methyl acrylate) and 1 part poly(ethyl acrylate)
- 76RES P-546: = vinylidene chloride/acrylate copolymer latex, 46% aqueous dispersion, from UNOCAL Chemicals Div. of Unocal Corp., Schaumburg, IL
- Polymatte: = butyl methacrylate/methyl methacrylate copolymer from Anderson Development Co., Adrian, MI
- Polymatte disperson: = 26 parts Polymatte, 0.52 Zonyl® FSN; and 73.48 parts water
- Zonyl® FSN: = perfluoroethoxylate surfactant from E. I. du Pont de Nemours & Co., Wilmington, DE
- Kraton® 1107: = styrene/isoprene/styrene block copolymer from Shell Chemical Co., Houston, TX
- HMDA: = 1,6-hexanediol diacrylate
- HMDMA: = 1,6-hexanediol dimethacrylate
- Initiator: = 2-phenyl-2,2-dimethoxyacetophenone
- Inhibitor: = 2,6-dimethyl-4-t-butyl phenol
- Red dye: = Neozapon® Red Dye from BASF Wyandotte Corp., Holland, MI
- HEMA: = hydroxyethyl methacrylate
- Shellflex® 371: = naphthenic oil containing 5-6 carbon cycloparaffins and saturate alkyl derivatives from Shell Chemical Co., Houston, TX
- Piccotex® 100S: = copolymer of vinyl toluene and alpha methyl styrene from Hercules Co., Wilmington, DE
- MABS: = copolymer of methyl methacrylate/acrylonitrile/butadiene/styrene, Blendex® 491 from GE Specialty Chemicals Co., Parkersburg, WV
- Blue dye: = Atlantic Fast Wool Blue R Dye from Atlantic Chemical Co., Nutley, NJ
- Macromelt® 6900: = polyamide from Henkel Corp., Minneapolis, MN
- Oxonol: = yellow dye from Riedel De Haën

### Example 1

This example illustrates the preparation of a support layer according to the invention.

The following ingredients were fed into a conventional unit for producing polyester film from pellets:

| Ingredient | Parts by weight |
|---|---|
| PET pellets | 99.19 |
| Blue 3R-RF | 0.57 |
| UV absorber | 0.24 |

The ingredients were melted down, and cast into a sheet of polyester base 7 mils (0.0178 cm) thick. The UV absorbance at 349 NM is 1.8-2.0.

The polyester sheet was coated on both sides with a subbing layer of CP1216 latex at a coating weight of 0.8 mg/dm², and then stretched in the longitudinal and transverse directions. After stretching, the following adhesive solution was applied by air knife coating at a coating weight of about 70 mg/dm²:

| Ingredient | Parts by weight |
|---|---|
| 76RES P-546 | 75.8 |
| Polymatte dispersion | 1.39 |
| Zonyl® FSN | 0.043 |
| Water | 22.74 |

### Example 2

This example illustrates the use of the support sheet prepared in Example 1 with a photosensitive layer to prepare a photosensitive element, and the improved characteristics of the flexographic printing plate made from that photosensitive element.

A multilayer cover element was prepared by coating a 5 mil (0.0127 cm) thick polyethylene terephthalate cover sheet with a layer of Macromelt® 6900 resin at a coating weight of 40 mg/dm².

Over the first coating was applied a second coating, at a coating weight of 480 mg/dm², with the following:

| Ingredient | Parts by weight |
|---|---|
| Kraton® 1107 | 66.7 |
| MABS | 31.5 |
| Blue dye | 1.8 |

A photopolymerizable composition was prepared from the following:

| Ingredient | Parts by weight |
|---|---|
| Kraton® 1107 | 72.6 |
| HMDA | 5.09 |
| HMDMA | 3.57 |
| Initiator | 1.94 |
| Inhibitor | 1.92 |
| Red dye | 0.0044 |
| HEMA | 0.1732 |
| Shellflex® 371 | 7.9 |
| Piccotex® 100S | 5.79 |
| Ceresin Wax | 0.97 |

The above ingredients were fed into an 83 mm twin screw extruder and extruded at 175°C between the adhesive side of the support sheet from Example 1 and the coated side of the multilayer covered element described above. The final thickness of the photosensitive element, excluding the polyethylene terephthalate cover sheet, was 45 mils (0.114 cm).

Flexographic printing plates were then prepared from the above photosensitive element. The element was exposed through the back side (the polyethylene terephthalate support sheet from Example 1) on the Cyrel® 30x40 exposure unit (E. I. du Pont de Nemours & Co., Wilmington, DE). The front side (multilayer cover element side) was then exposed for 8 minutes through a photographic negative. The exposed element was washed out for 5 minutes in the Cyrel® 30x40 rotary processor (E. I. du Pont de Nemours & Co., Wilmington, DE) using tetrachloroethylene/n-butanol (75/25 volume percent) as the developing solvent, and then dried in an oven at 60°C for 2 hours. Following drying, the plate was detackified and post exposed for 8 minutes in a Cyrel® Light Finish/Post Exposure unit (Cyrel 3248 LT-Fin-PX, E. I. du Pont de Nemours & Co., Wilmington, DE).

The finished plate had a very smooth floor with no bumps or imperfections which could interfere with printing.

### Comparative Example 3

This example illustrate the preparation of a support layer with the antihalation dye in the adhesive layer.

A polyethylene terephthalate sheet 8.5 mils (0.0216 cm) thick, was prepared using the procedure described in U.S. Patents 2,968,067 and 2,779,684. The sheet was coated on both sides with the same subbing layer described in Example 1 and then stretched in both the longitudinal and transverse directions. After stretching, the following adhesive solution was applied by air knife coating at a coating weight of about 70 mg/dm²;

| Ingredient | Parts by weight |
|---|---|
| 76RES P-546 | 74.31 |
| Polymatte dispersion | 1.30 |
| Oxonol®, 16% aqueous solution | 7.43 |
| Zonyl® FSN | 0.024 |
| Water | 16.93 |

### Comparative Example 4

This example illustrates the inferior quality of printing plates made using the support sheet from Comparative Example 3.

The ingredients for the photopolymerizable composition described in Example 2 were fed into an 83 mm twin screw extruder and extruded at 175°C between the adhesive side of the support sheet from Comparative Example 3 and the coated side of a multilayer cover element at described in Example 2.

A printing plate was prepared from the above photosensitive element using the steps described in Example 2. The finished plate had many visible bumps in the floor.

## Claims

1. A photosensitive printing element comprising:
(a) a transparent film support comprising a synthetic resin and at least 0.1 weight %, based on the weight of the film, of an antihalation agent;
(b) a transparent adhesive layer; and
(c) a photopolymerizable layer comprising (i) at least one nongaseous ethylenically unsaturated monomer, (ii) a photoinitiator system and (iii) an elastomeric binder comprising polymerized conjugated diene monomers.

2. The photosensitive printing element of claim 1 wherein the transparent film support is polyethylene terephthalate.

3. The photosensitive printing element of claim 1 wherein the transparent adhesive layer comprises vinylidene chloride.

4. The photosensitive printing element of claim 1 which further comprises a multilayer cover element consisting essentially of a flexible cover film, optionally a flexible polymeric film, and a layer of an elastomeric composition which is photosensitive or becomes photosensitive by contact with the photopolymerizable layer.

5. A process for improving the printing quality of a flexographic photosensitive plate comprising:
(a) imagewise exposing a photosensitive printing element having:
(i) a transparent film support comprising a synthetic resin and at least 0.1 weight %, based on the weight of the film, of an antihalation agent;
(ii) a transparent adhesive layer; and
(iii) a photopolymerizable layer comprising (1) at least one nongaseous ethylenically unsaturated monomer, (2) a photoinitiator system and (3) an elastomeric binder comprising polymerized conjugated diene monomers.
(b) removing the non-polymerized unexposed areas of the photopolymerizable layer; and
(c) applying post development treatment; wherein the printing quality is substantially improved by adding an antihalation agent to the transparent film support.

6. The process of claim 5 wherein the photosensitive element comprises a multilayer cover element adjacent to the photopolymerizable layer, said cover element consisting essentially of a flexible cover film, optionally a flexible polymeric film, and a layer of an elastomeric composition which is photosensitive or becomes photosensitive by contact with the photopolymerizable layer.

7. The process of claim 5 wherein the transparent film support is polyethylene terephthalate.

8. The process of claim 5 wherein the transparent adhesive layer comprises vinylidene chloride.

## Patentansprüche

1. Lichtempfindliches Druckelement, umfassend:
(a) einen transparenten Filmträger, umfassend ein synthetisches Harz und wenigstens 0,1 Gew.-%, bezogen auf das Gewicht des Films, eines Lichthofschutzmittels;
(b) eine transparente Klebstoffschicht und
(c) eine photopolymerisierbare Schicht, umfassend (i) wenigstens ein nicht gasförmiges, ethylenisch ungesättigtes Monomer, (ii) ein Photoinitiator-System und (iii) ein elastomeres Bindemittel, das polymerisierte, konjugierte Dienmonomere umfaßt.

2. Lichtempfindliches Druckelement nach Anspruch 1, wobei der transparente Filmträger Polyethylenterephthalat ist.

3. Lichtempfindliches Druckelement nach Anspruch 1, wobei die transparente Klebstoffschicht Vinylidenchlorid umfaßt.

4. Lichtempfindliches Druckelement nach Anspruch 1, das weiterhin ein Mehrschicht-Deckelement umfaßt, das im wesentlichen aus einem biegsamen Deckfilm, gegebenenfalls einem biegsamen, polymeren Film und einer Schicht aus einer elastomeren Zusammensetzung besteht, die lichtempfindlich ist oder durch Kontakt mit der photopolymerisierbaren Schicht lichtempfindlich wird.

5. Verfahren zur Verbesserung der Druckqualität einer flexographischen, lichtempfindlichen Platte, umfassend das:
(a) bildweise Belichten eines lichtempfindlichen Druckelements mit:
(i) einem transparenten Filmträger, umfassend ein synthetisches Harz und wenigstens 0,1 Gew.-%, bezogen auf das Gewicht des Films, eines Lichthofschutzmittels;
(ii) eine transparente Klebstoffschicht und
(iii) eine photopolymerisierbare Schicht, umfassend (1) wenigstens ein nicht gasförmiges, ethylenisch ungesättigtes Monomer, (2) ein Photoinitiator-System und (3) ein elastomeres Bindemittel, umfassend polymerisierte, konjugierte Dienmonomere;
(b) Entfernen der nicht polymerisierten, unbelichteten Bereiche der photopolymerisierbaren Schicht; und das
(c) Anwenden einer Nachentwicklungs-Behandlung;
wobei die Druckqualität wesentlich verbessert wird, indem ein Lichthofschutzmittel zu dem transparenten Filmträger gegeben wird.

6. Verfahren nach Anspruch 5, wobei das lichtempfindliche Element ein Mehrschicht-Deckelement umfaßt, das an die photopolymerisierbare Schicht angrenzt, wobei das Deckelement im wesentlichen aus einem biegsamen Deckfilm, gegebenenfalls einem biegsamen, polymeren Film und einer Schicht aus einer elastomeren Zusammensetzung, die lichtempfindlich ist oder durch Kontakt mit der photopolymerisierbaren Schicht lichtempfindlich wird, besteht.

7. Verfahren nach Anspruch 5, wobei der transparente Filmträger Polyethylenterephthalat ist.

8. Verfahren nach Anspruch 5, wobei die transparente Klebstoffschicht Vinylidenchlorid umfaßt.

## Revendications

1. Elément d'impression photosensible comprenant:
(a) un rapport de film transparent comprenant une résine synthétique et au moins 0,1% en poids, par rapport au poids du film, d'un agent antihalo;
(b) une couche adhésive transparente; et
(c) une couche photopolymérisable comprenant (i) au moins un monomère non gazeux à insaturation éthylénique, (ii) un système photoinitiateur et (iii) un liant élastomère comprenant des monomères diéniques conjugués polymérisés.

2. Elément d'impression photosensible selon la revendication 1, dans lequel le support de film transparent est le polyéthylène-téréphtalate.

3. Elément d'impression photosensible selon la revendication 1, dans lequel la couche adhésive transparente comprend du chlorure de vinylidène.

4. Elément d'impression photosensible selon la revendication 1, qui comprend en outre un élément de couverture multicouche constitué essentiellement d'un film de couverture flexible, éventuellement un film polymère flexible, et d'une couche d'une composition élastomère qui est photosensible ou qui devient photosensible au contact de la couche photopolymérisable.

5. Procédé d'amélioration de la qualité d'impression d'une plaque flexographique photosensible comprenant les étapes consistant à:
(a) exposer selon une image un élément d'impression photosensible comprenant:
(i) un support de film transparent comprenant une résine synthétique et au moins 0,1% en poids, par rapport au poids du film, d'un agent antihalo;
(ii) une couche adhésive transparente; et
(iii) une couche photopolymérisable comprenant (1) au moins un monomère non gazeux à insaturation éthylénique, (2) un système photoinitiateur et (3) un liant élastomère comprenant des monomères diéniques conjugués polymérisés
(b) éliminer les zones non polymérisées non exposées de la couche photopolymérisable; et
(c) appliquer un traitement de post-développement dans lequel la qualité d'impression est sensiblement améliorée par addition d'un agent antihalo au support de film transparent.

6. Procédé selon la revendication 5, dans lequel l'élément photosensible comprend un élément de couverture multicouche adjacent à la couche photopolymérisable, ledit élément de couverture étant essentiellement constitué d'un film de couverture flexible, éventuellement d'un film polymère flexible, et d'une couche d'une composition élastomère qui est photosensible ou qui devient photosensible au contact de la couche photopolymérisable.

7. Procédé selon la revendication 5, dans lequel le support de film transparent est le polyéthylène-téréphtalate.

8. Procédé selon la revendication 5, dans lequel la couche adhésive transparente comprend du chlorure de vinylidène.
